# EUROPEAN PATENT APPLICATION

(11) **EP 4 730 628 A1**
(43) Date of publication of application: **22.04.2026**
(21) Application number: 25306715.1
(22) Date of filing: 15.10.2025
(51) Int. Cl.: H02M 1/00, H02M 3/00, H02M 1/36, H02J 1/04

(54) **PRE-CHARGING CIRCUIT**

(30) Priority: 16.10.2024 CN 202411444452; 28.03.2025 CN 202510386413
(71) Applicant: SCHNEIDER ELECTRIC INDUSTRIES SAS, 92500 Rueil-Malmaison (FR)
(72) Inventor: LIU, Xia, Shanghai, 201203 (CN); FANG, Yun, Shanghai, 201203 (CN); SHI, Ying, Shanghai, 201203 (CN); ZHANG, Fenglian, Shanghai, 201203 (CN); LIU, Jiawei, Shanghai, 201203 (CN); TIAN, Simon, Shanghai, 201203 (CN); WANG, Shunyao, Shanghai, 201203 (CN); CHEN, Jiamin, Shanghai, 201203 (CN)
(74) Representative: Manitz Finsterwald Patent- und Rechtsanwaltspartnerschaft mbB

(57) **Abstract**

A pre-charging circuit is disclosed, including: a first switching device connected between a power supply and a load, configured to turn on and off the power supply and the load to control power supplying and pre-charging of the load by the power supply; and a pre-charging device connected to the first switching device, configured to, in a pre-charging mode: obtain a magnitude of a pre-charging current for the load, compare the magnitude of the pre-charging current with a first current threshold and a second current threshold, wherein the first current threshold is less than the second current threshold, and control the first switching device to be turned on or turned off based on a comparison result.

## Description

### CROSS-REFERENCE TO RELATED APPLICATION

This application is based on and claims priority to Chinese Patent Application No. 202411444452.9, filed on October 16, 2024 and Chinese Patent Application No. 202510386413.6, filed on March 28, 2025 in the Chinese Patent Office, the contents of which being herein incorporated by reference in its entirety.

### TECHNICAL FIELD

The present invention relates to power systems, and in particular to pre-charging circuits.

### BACKGROUND

Electric loads may include large capacity capacitive loads. These capacitive loads may not store any energy before they are powered on. At the moment the circuit is closed, these large capacity capacitive loads may be charged. During the charging process, a large inrush current may be generated, like directly to become a short circuit. Without proper control, such a large inrush current can cause serious damage to circuit devices such as power supplies and relays. Furthermore, the inrush current may cause functions such as overcurrent protection to be falsely triggered. Such inrush current may be reduced by pre-charging circuit, thus protecting the circuit device and prolonging its service life.

Generally, the pre-charging current may be implemented using a combination of a power resistor and a relay. In addition, the pre-charging circuit may be implemented through a scheme that uses voltage loop feedback to control PWM. Moreover, the contactors used for pre-charging are susceptible to wear and have a slow response speed, and the charging speed of the pre-charging circuit is slow. Such pre-charging circuits have relatively rough control over the charging current during the pre-charging process, which may cause the overcurrent protection function to be falsely triggered.

Therefore, a pre-charging circuit is expected, which can accurately control the magnitude of pre-charging current in the process of pre-charging the load, and has the advantages of less required devices, low cost, small occupied space and fast pre-charging speed.

### SUMMARY

The present disclosure provides a pre-charging circuit comprising: a first switching device connected between a power supply and a load, configured to turn on and off the power supply and the load to control power supplying and pre-charging of the load by the power supply; and a pre-charging device connected to the first switching device, configured to, in a pre-charging mode: obtain a magnitude of a pre-charging current for the load, compare the magnitude of the pre-charging current with a first current threshold and a second current threshold, wherein the first current threshold is less than the second current threshold, and control the first switching device to be turned on or turned off based on a comparison result.

According to an embodiment of the present disclosure, the pre-charging circuit further comprising a voltage clamping device connected in parallel with switching device, wherein, the voltage clamping device conducts a pre-charging current flowing through the load in the pre-charging mode, in response to the first switching device being turned off.

According to an embodiment of the present disclosure, the pre-charging circuit further comprising a control device configured to control the pre-charging device to enter or exit the pre-charging mode.

According to an embodiment of the present disclosure, the pre-charging circuit further comprising a voltage measurement device, the control device is configured to: measure a power supply voltage and a load voltage by the voltage measurement device, enter the pre-charging mode, based on a voltage difference between the power supply voltage and the load voltage being greater than a voltage difference threshold.

According to an embodiment of the present disclosure, wherein the control device is further configured to: detect whether a second switching device changes from an off state to an on state, wherein the second switching device is connected in series with the first switching device and comprises a mechanical switch, control the pre-charging device to enter the pre-charging mode, in response to detecting that the second switching device changes from the off state to the on state.

According to an embodiment of the present disclosure, wherein the control device is further configured to: control the first switching device to be turned on, in response to detecting that the second switching device changes from the off state to the on state, determine whether an instantaneous tripping device turns off the first switching device, control the pre-charging device to enter the pre-charging mode after a first threshold time, in response to determining that the instantaneous tripping device turns off the first switching device.

According to an embodiment of the present disclosure wherein the control device is further configured to: determine whether the instantaneous tripping device turns off the first switching device in the case that the power supply supplies power to the load through the first switching device being turned on and the second switching device being turned on, wherein the second switching device is connected in series with the first switching device and comprises a mechanical switch, control the pre-charging device to enter the pre-charging mode after a first threshold time, in response to determining that the instantaneous tripping device turns off the first switching device.

According to an embodiment of the present disclosure, wherein the control device is configured to control the pre-charging device to exit the pre-charging mode based on at least one of the following: the pre-charging device completes the pre-charging of the load; the pre-charging of the load is not completed, in the case that a pre-charging time is greater than a second threshold time.

According to an embodiment of the present disclosure, wherein the control device is configured to: in response to the pre-charging device completing the pre-charging of the load, control the pre-charging device to exit the pre-charging mode and continue to turn on the first switching device.

According to an embodiment of the present disclosure, the pre-charging circuit further comprising a voltage measurement device, the control device is configured to: measure a power supply voltage and a load voltage by the voltage measurement device, determine that the pre-charging device completes the pre-charging of the load, based on a voltage difference between the power supply voltage and the load voltage being smaller than a voltage difference threshold.

According to an embodiment of the present disclosure, wherein the pre-charging device is configured to output a control signal having a first level to indicate the first switching device to be turned on, and output a control signal having a second level to indicate the first switching device to be turned off, wherein the control device is further configured to: in response to the control signal output by the pre-charging device maintaining the first level for at least a third threshold time, determine that the pre-charging device completes the pre-charging of the load.

According to an embodiment of the present disclosure, wherein the control device is further configured to: in response to the pre-charging of the load not being completed in the case that the pre-charging time is greater than the second threshold time, exit the pre-charging mode and turn off the first switching device.

According to an embodiment of the present disclosure, wherein the pre-charging device is configured to output a control signal with a first level to indicate the first switching device to be turned on, and output a control signal with a second level to indicate the first switching device to be turned off, wherein the control device is further configured to: in response to the control signal output by the pre-charging device switching between the first level and the second level for a third threshold time, determine that the pre-charging device does not complete the pre-charging of the load.

According to an embodiment of the present disclosure, the pre-charging circuit further comprising a voltage measurement device, the control device is configured to: measure a power supply voltage and a load voltage by the voltage measurement device, determine that the pre-charging device does not complete the pre-charging of the load, based on a voltage difference between the power supply voltage and the load voltage being greater than a voltage difference threshold.

According to an embodiment of the present disclosure, the pre-charging circuit further comprising a driver device configured to drive the first switching device to be turned on or turned off based on a control signal.

According to an embodiment of the present disclosure, wherein the driver device is configured to receive a control signal indicating to turn on or turn off the first switching device from the control device or the pre-charging device.

According to an embodiment of the present disclosure, the pre-charging circuit further comprising an instantaneous tripping device configured to send a control signal to the driver device indicating to turn off the first switching device in response to the pre-charging current of the load being greater than a third current threshold, wherein the driver device controls the first switching device to turn off, in response to receiving a control signal indicating to turn off the first switching device from at least one of the pre-charging device and the instantaneous tripping device.

According to an embodiment of the present disclosure, wherein the first switching device comprises a solid-state switch.

According to an embodiment of the present disclosure, wherein the pre-charging device comprises: a current sensor connected between the first switching device and the load, an operation amplifier module configured to amplify a voltage of the current sensor and output an amplified voltage of the current sensor to a first comparison module and a second comparison module, the first comparison module configured to receive the amplified voltage of the current sensor, wherein comparing the magnitude of the pre-charging current with the first current threshold comprises comparing, by the first comparison module, the amplified voltage of the current sensor with the first voltage threshold to output a first comparison signal, the second comparison module configured to receive the amplified voltage of the current sensor, wherein comparing the magnitude of the pre-charging current with the second current threshold comprises comparing, by the second comparison module, the amplified voltage of the current sensor with the second voltage threshold to output a second comparison signal, the first voltage threshold being greater than the second voltage threshold, a logic operation module configured to receive the first comparison signal and the second comparison signal and perform a logic operation on the first comparison signal and the second comparison signal to output a control signal indicating to turn on or turn off the first switching device.

According to an embodiment of the present disclosure, wherein controlling the first switching device to be turned on or turned off based on the comparison result comprises: in response to the magnitude of the pre-charging current being less than or equal to the first current threshold, controlling the first switching device to be turned on, in response to the magnitude of the pre-charging current being greater than or equal to the second current threshold, controlling the first switching device to be turned off.

According to an embodiment of the present disclosure, the pre-charging circuit further comprising a current measurement module, wherein the pre-charging device obtains the magnitude of the pre-charging current for the load by the current measurement module.

According to an embodiment of the present disclosure, wherein controlling the first switching device to be turned on or turned off based on the comparison result comprises: in response to the magnitude of the pre-charging current being between the first current threshold and the second current threshold, controlling the first switching device to be turned on based on an increase in the magnitude of the pre-charging current over time; and in response to the magnitude of the pre-charging current being between the first current threshold and the second current threshold, controlling the first switching device to be turned off based on a decrease in the magnitude of the pre-charging current over time.

The present disclosure provides a method for a pre-charging circuit, comprising: controlling a power supply to pre-charge a load by turning on and off the power supply and the load through a first switching device connected between the power supply and the load; and obtaining a magnitude of a pre-charging current for the load in a pre-charging mode through a pre-charging device connected to the first switching device; comparing the magnitude of the pre-charging current with a first current threshold and a second current threshold, wherein the first current threshold is less than the second current threshold; and controlling the first switching device to be turned on or turned off based on a comparison result.

The present disclosure provides a non-transitory computer-readable storage medium having computer-executable instructions stored thereon, wherein the computer-executable instructions, when executed by a processor, can implement the above method.

The pre-charging circuit disclosed herein can accurately control the magnitude of pre-charging current in the process of pre-charging the load. Furthermore, the pre-charging circuit has the advantages of less required devices, low cost, small occupied space and fast pre-charging speed.

### BRIEF DESCRIPTION OF DRAWINGS

The above and other aspects, features and advantages of certain embodiments of the present disclosure will become more apparent from the following description taken in conjunction with the accompanying drawings, in which:
FIG. 1 is a schematic diagram of a pre-charging circuit according to an embodiment of the present disclosure.
FIG. 2 is a schematic diagram of another pre-charging circuit according to an embodiment of the present disclosure.
FIG. 3 is a circuit diagram of a pre-charging circuit according to an embodiment of the present disclosure.
FIG. 4 is a flowchart of a method for pre-charging circuit according to an embodiment of the present disclosure.
FIGs. 5A-5C are flowcharts of another method for pre-charging circuit according to an embodiment of the present disclosure.
FIG. 6 is a flowchart of another method for pre-charging circuit according to an embodiment of the present disclosure.
FIG. 7 is a non-transitory computer-readable storage medium according to at least one embodiment of the present disclosure.

### DETAILED DESCRIPTION

Before proceeding with the following detailed description, it may be helpful to set forth definitions of certain words and phrases used throughout this disclosure. The terms "include" and "comprise" and their derivatives mean including, but not limited to, including. The phrase "at least one of," when used with a list of items, means that different combinations of one or more of the listed items may be used, and only one item from the list may be required. For example, "at least one of A, B, and C" includes any of the following combinations: A, B, C, A and B, A and C, B and C, and A, B, and C.

Definitions for other specific words and phrases are provided throughout this disclosure. Those of ordinary skill in the art should understand that in many, if not most instances, such definitions apply to prior and future uses of such defined words and phrases.

The various embodiments of the principles of the present disclosure in this patent application document are described below in conjunction with the accompanying drawings for illustration only and should not be interpreted as limiting the scope of the present disclosure in any way. It will be understood by those skilled in the art that the principles of the present disclosure may be implemented in any appropriately arranged system or device. In some cases, the actions described in the present disclosure may be performed in a different order and can still achieve the desired result. In addition, the process depicted in the accompanying drawings does not necessarily require the specific order shown or the sequential order to achieve the desired result. In a specific embodiment, multitasking and parallel processing may be advantageous.

The text and drawings are provided as examples only to aid understanding of the present disclosure. They should not be interpreted as limiting the scope of the claims appended hereto in any way. Throughout the drawings, the same reference numerals generally indicate the same elements. Although certain embodiments and examples have been provided, it will be clear to those skilled in the art based on the contents of this disclosure that the illustrated embodiments and examples may be modified without departing from the scope of this disclosure.

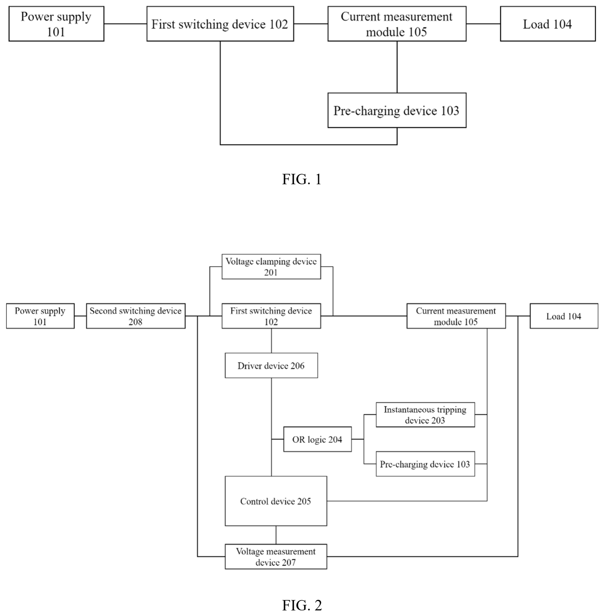

FIG. 1 is a schematic diagram of a pre-charging circuit according to an embodiment of the present disclosure.

As shown in FIG. 1, the pre-charging circuit may include a first switching device 102 and a pre-charging device 103.

The first switching device 102 may be connected between the power supply 101 and the load 104. For example, a first end of the first switching device 102 may be connected to the power supply 101, and a second end of the first switching device 102 may be connected to the load 104 via the current measurement module 105. The first switching device 102 may turn on and off the power supply 101 and the load 104 to control the power supply of the power supply 101 to the load 104. For example, by controlling the first switching device 102 to be turned on and turned off, the power supply 101 may be controlled to provide the load 104 with the power required for the operation of the load 104. In addition, the first switching device 102 may turn on and off the power supply 101 and the load 104 to control the pre-charging of the load 104 by the power supply 101. For example, by controlling the first switching device 102 to be turned on and turned off, the power supply 101 may be controlled to pre-charge a capacitive load in the load 104, thereby reducing the inrush current at the start of power supply.

The first end of the current measurement module 105 may be connected to the first switching device 102, and a second end of the current measurement module 105 may be connected to the load 104. The current measurement module 105 may be configured to measure currents flowing through the power supply 101, the first switching device 102, and the load 104, such as charging current and supply current.

The pre-charging device 103 may obtain the magnitude of the pre-charging current for the load 104. For example, the pre-charging device 103 may obtain the magnitude of the pre-charging current through the current measurement module 105. Part or all of the current measurement module 105 may or may not be part of the pre-charging circuit. For example, part or all of the current measurement module 105 may or may not be part of the pre-charging device 103. In pre-charging mode, the pre-charging device 103 may obtain the magnitude of the pre-charging current and compare the magnitude of the pre-charging current with a first current threshold and a second current threshold. The first current threshold may be less than the second current threshold. For example, the first current threshold may be the lower limit threshold of the pre-charging current. The second current threshold may be the upper limit threshold of the pre-charging current. The first current threshold can ensure the pre-charging speed, thereby quickly pre-charging the load. In addition, by properly configuring the first current threshold, the number of switching operations of the first switching device 102 during the pre-charging process may be reduced. The second current threshold may ensure that the life of the circuit device is not affected by the pre-charging process or alleviate the influence of the pre-charging process on the life of the circuit device. For example, the second current threshold may be a current that has no influence on the life of the circuit device or has a small enough influence to be negligible in relevant standards or tests. The pre-charging device 103 may be connected to the first switching device 102 to control the first switching device 102 to be turned on or off based on the comparison result of the pre-charging current with the first current threshold and the second current threshold, thereby pre-charging the load 104.

FIG. 2 is a schematic diagram of another pre-charging circuit according to an embodiment of the present disclosure.

As shown in FIG. 2, the pre-charging circuit further includes one or more of a voltage clamping device 201, an instantaneous tripping device 203, an OR logic 204, a control device 205, and a driver device 206. Additionally or alternatively, the pre-charging circuit may further include one or more of a voltage measurement device 207 and a second switching device 208.

As described with reference to FIG. 1, the first switching device 102 and the second switching device 208 may be connected in series to turn on and off the power supply 101 and the load 104 to control the power supply of the power supply 101 to the load 104.

The first switching device 102 may include a solid-state switch, for example, a metal-oxide semiconductor field effect transistor (MOSFET), but the present disclosure is not limited thereto. For example, the first switching device 102 may include a plurality of metal-oxide semiconductor field effect transistors (MOSFETs) connected in parallel.

The second switching device 208 may include a mechanical switch. For example, the second switching device 208 may include one or more of a manually operated mechanical switch, an electrically operated mechanical switch, and a spring-loaded mechanical switch, but the present disclosure is not limited thereto. In one embodiment, the second switching device 208 may be turned on by, for example, on-site manual operation by a user or by remote control (e.g., a switch-on action).

The voltage clamping device 201 may be a metal oxide varistor (MOV), but the present disclosure is not limited thereto. The voltage clamping device 201 may be connected in parallel with the first switching device 102. In pre-charging mode, in response to the first switching device 102 being turned off, the voltage clamping device 201 may conduct the pre-charging current flowing through the load 104. For example, there may be an inductive component in the load 104 or the pre-charging current path. In response to the first switching device 102 being turned off, a very large voltage may be generated across the first switching device 102 due to the inductive component. In response to this very large voltage, the voltage clamping device 201 may be turned on, thereby protecting the circuit device. Additionally or alternatively, the voltage clamping device 201 may also be replaced with a transient voltage suppression (TVS) diode.

The control device 205 may obtain the operating state of the second switching device 208 and the instantaneous tripping device 203. The control device 205 may include one or more of hardware, software, or a combination of hardware and software. For example, the control device 205 may include a microcontroller unit (MCU) or a control circuit formed purely in hardware form, but the present disclosure is not limited thereto. Other forms of control devices capable of implementing control and signal processing are also possible.

In one embodiment, the control device 205 may obtain the operating state of the second switching device 208 to determine whether the second switching device 208 transitions from an off state to an on state. For example, when the power supply 101 and the load 104 are connected to supply power to the load 104, the second switching device 208 may be turned on manually on-site by a user or through remote control. The control device 205 may obtain the operating state of the second switching device 208 being turned on to determine whether to turn on the first switching device 102 to supply power, and whether to enter the pre-charging mode to perform pre-charging through the pre-charging device 103.

In another embodiment, the control device 205 may obtain the operating state of the instantaneous tripping device 203 to determine whether the instantaneous tripping device 203 performs a tripping operation. A tripping operation may refer to the instantaneous tripping device 203 controlling the first switching device 102 to turn off. For example, when the instantaneous tripping device 203 performs a tripping operation in response to a tripping event such as a surge current, the control device 205 may obtain the operating state of the instantaneous tripping device 203 performing a tripping operation. Based on the instantaneous tripping device 203 performing a tripping operation, the control device 205 may determine whether to attempt to turn on the first switching device 102 again after a first threshold time has passed, and whether to enter a pre-charging mode to perform pre-charge via the pre-charge device 103. The first threshold time may be greater than the duration of the tripping event that caused the instantaneous tripping device 203 to perform a tripping operation. According to one embodiment of the present disclosure, the tripping event may include a surge current, the duration of the surge current may generally be less than 1 millisecond. In this case, the first threshold time may be set to 1 millisecond. By attempting to turn on the first switching device 102 again after 1 millisecond, the instantaneous tripping device 203 may be prevented from repeatedly performing tripping operation due to the same tripping event. Those skilled in the art will understand that the specific value of the first threshold time described above is merely an example, and a longer or shorter first threshold time may be set depending on the specific application scenario and the specific tripping event.

As an optional embodiment, the control device 205 may obtain the power supply voltage of the power supply 101 and the load voltage of the load 104 through the voltage measurement device 207. The control device 205 may determine to enter the pre-charging mode, for example, by activating the pre-charging device 103, based on the voltage difference between the power supply voltage and the load voltage being greater than a voltage difference threshold. For example, when the voltage difference between the power supply voltage and the load voltage is greater than the voltage difference threshold, the control device 205 may determine that if the first switching device 102 is turned on, a large inrush current will be generated. Therefore, the control device 205 may determine to use the pre-charging circuit to pre-charge the load 104. Furthermore, the control device 205 may exit the pre-charging mode and turn on the first switching device 102, for example, by deactivating the pre-charging device 103, based on the voltage difference between the power supply voltage of the power supply 101 and the load voltage of the load 104 being less than a voltage difference threshold. For example, when the voltage difference between the power supply voltage and the load voltage is less than the voltage difference threshold, the control device 205 may determine that if the first switching device 102 is turned on, no inrush current, or a smaller or allowable inrush current will be generated. Therefore, the control device 205 may determine to exit the pre-charging mode to stop using the pre-charging circuit to pre-charge the load 104, and the control device 205 may turn on the first switching device 102 to supply power to the load 104. As an example, the voltage difference threshold may be 16.5V.

The control device 205 may obtain the magnitude of the pre-charging current or the magnitude of the supply current through the current measurement module 105 to perform other functions such as overload protection.

The control device 205 may exit the pre-charging mode and turn off the switching device, based on the pre-charging time being greater than a second threshold time and the pre-charging of the load is still not completed. In the case that the pre-charging time is greater than the second threshold time and the pre-charging of the load is still not completed, a short circuit fault may have occurred. As an example, the second threshold time may be 10ms. Those skilled in the art will understand that the specific value of the second threshold time described above is merely an example, and a longer or shorter second threshold time may be set depending on the specific application scenario.

The driver device 206 may drive the first switching device 102 to be turned on or off based on the control signal. For example, the driver device 206 may drive the first switching device 102 to be turned on or off based on the control signal from the control device 205, the instantaneous tripping device 203, or the pre-charging device 103, which indicates that the first switching device 102 to be turned on or off.

The instantaneous tripping device 203 and the pre-charging device 103 may obtain the magnitude of the pre-charging current through the current measurement module 105. Based on the magnitude of the pre-charging current, the instantaneous tripping device 203 and the pre-charging device 103 may output a control signal to the driver device 206, thereby controlling the driver device 206 to drive the first switching device 102 to be turned on or off. The instantaneous tripping device 203 and the pre-charging device 103 may input the control signal for the driver device 206 into the OR logic 204, and the OR logic 204 inputs the control signal to the driver device 206. For example, in response to a control signal output by at least one of the instantaneous tripping device 203 and the pre-charging device 103 indicating the driver device 206 to turn off the first switching device 102, the OR logic 204 may output a control signal that controls the driver device 206 to drive the first switching device 102 to turned off. In response to control signals output by both the instantaneous tripping device 203 and the pre-charging device 103 indicating the driver device 206 to turn on the first switching device 102, the OR logic 204 may output a control signal that controls the driver device 206 to drive the first switching device 102 to be turned on. The OR logic 204 is provided only as an example, and other logic operation devices capable of implementing the above logic operation are also possible.

For example, in response to the magnitude of the pre-charging current being less than or equal to a first current threshold, the pre-charging device 103 may output a control signal that controls the first switching device 102 to be turned on. In response to the magnitude of the pre-charging current being greater than or equal to a second current threshold, the pre-charging device 103 may output a control signal that controls the first switching device 102 to be turned off.

The instantaneous tripping device 203 may send a control signal indicating to turn off the first switching device 102 to the driver device in response to the charging current of the load 104 being greater than the third current threshold. The third current threshold may be greater than both the first current threshold and second current threshold. The third current threshold may be the magnitude of the current corresponding to the hardware protection function, such as the magnitude of the current in the case of a tripping event as described above. As an example, the first current threshold may be 4A, the second current threshold may be 20A, and the third current threshold may be 200A.

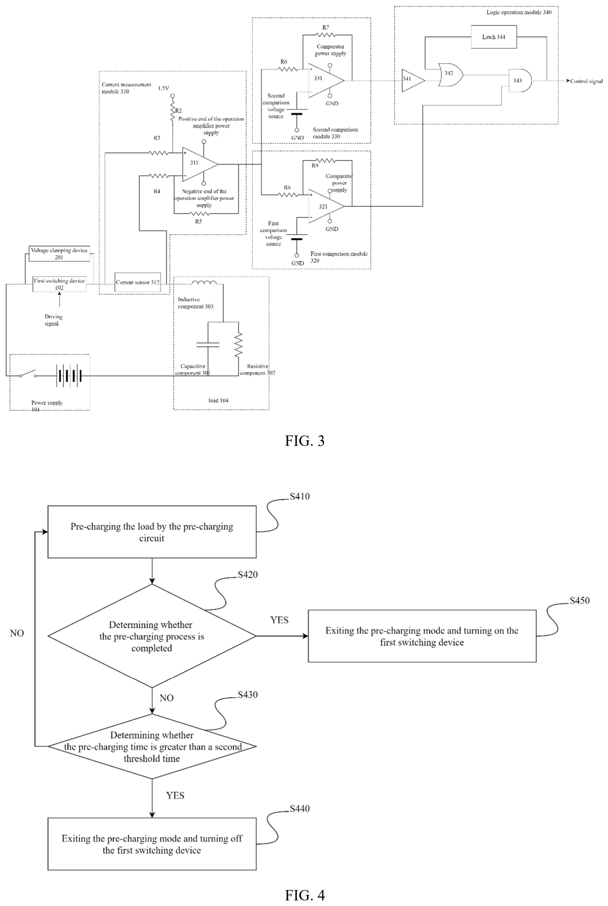

FIG. 3 is a circuit diagram of a pre-charging circuit according to an embodiment of the present disclosure.

In FIG. 3, a pre-charging device (e.g., pre-charging device 103 in FIG. 1 and FIG. 2) may include one or more of a first comparison module 320, a second comparison module 330, and a logic operation module 340. However, the present disclosure is not limited thereto, and the pre-charging device may include more or fewer components. For example, the current measurement module 310 may or may not be part of the pre-charging device.

As shown in FIG. 3, in pre-charging mode, the first switching device 102 may be turned on or off based on a drive signal from the driver device 206 of FIG. 2. When the first switching device 102 is turned on, a pre-charging current may flow through the power supply 101, the first switching device 102, and the load 104, thereby pre-charging the inductive load (e.g., the capacitive component 301 and the resistive component 302) in the load 104. In pre-charging mode, when the first switching device 102 is turned off, a large voltage may be generated across the voltage clamping device 201 due to the inductive component 303 in the load 104, causing the voltage clamping device 201 to be turned on. The pre-charging current may flow through the power supply 101, the voltage clamping device 201, the current sensor 312, and the load 104, thereby continuing to pre-charge the capacitive component 301 in the load 104. Although FIG. 3 shows an inductive component 303 in the load 104, the inductive component 303 is not necessary. When the inductive component 303 does not exist in the load 104, when the first switching device 102 is turned off, the magnitude of the pre-charging current may be zero.

The current measurement module 310 may include a current sensor 312 and an operation amplifier module. The current sensor 312 may be connected between the first switching device 102 and the load 104. For example, a first end of the current sensor 312 may be connected to the first switching device 102, and a second end of the current sensor 312 may be connected to the load 104. The operation amplifier module may include resistors R2 - R5 and an operation amplifier 311. The first end of resistor R2 may be connected to a voltage of 1.5V, and the second end of resistor R2 may be connected to the positive input end of the operation amplifier 311. The first end of resistor R3 may be connected to the first end of the current sensor 312, and the second end of resistor R3 may be connected to the positive input end of the operation amplifier 311. The first end of resistor R4 may be connected to the second end of the current sensor 312, and the second end of resistor R4 may be connected to the negative input end of the operation amplifier 311. The first end of resistor R5 may be connected to the negative input end of the operation amplifier 311, and the second end of resistor R5 may be connected to the output end of the operation amplifier 311. By configuring the values of resistors R2 - R5, the current measurement module 310 may amplify the voltage on the current sensor 312 by, such as 10 times. As an example, the current sensor 312 may be a shunt resistor, and the resistance value of the shunt resistor may be 0.5 mΩ, the resistance value of resistor R2 may be 10 kΩ, the resistance value of resistor R3 may be 1 kΩ, the resistance value of resistor R4 may be 1 kΩ, and the resistance value of resistor R5 may be 10 kΩ. Those skilled in the art will appreciate that other implementations of the current sensor 312 are also possible through appropriate configuration. The current measurement module 310 may output the amplified voltage on the current sensor 312 to the first comparison module 320 and the second comparison module 330.

The first comparison module 320 may include resistors R8 - R9, a first comparison voltage source, and a first comparator 321. A first end of resistor R8 may be connected to the current measurement module 310, and a second end of resistor R8 may be connected to the positive input end of the first comparator 321. A first end of resistor R9 may be connected to the positive input end of the first comparator 321, and a second end of resistor R9 may be connected to the output end of the first comparator 321. The first comparison voltage source may be connected to the negative input end of the first comparator 321. The first comparison module 320 may output a first comparison signal to the logic operation module 340. For example, by configuring the values of resistors R8 -R9 and the voltage value of the first comparison voltage source, the first comparison module 330 may output a low level to the logic operation module 340 when the pre-charging current is less than a first current threshold, and may output a high level to the logic operation module 340 when the pre-charging current is higher than the first current threshold. As an example, the resistance value of the resistor R8 may be 1 kΩ, the resistance value of the resistor R9 may be 1,000 kΩ, and the voltage value of the first comparison voltage source may be 1.52V.

The second comparison module 330 may include resistors R6 - R7, a second comparison voltage source, and a second comparator 321. A first end of resistor R6 may be connected to the current measurement module 310, and a second end of resistor R6 may be connected to the positive input end of the second comparator 331. A first end of resistor R7 may be connected to the positive input end of the second comparator 331, and a second end of resistor R7 may be connected to the output end of the second comparator 331. The second comparison voltage source may be connected to the negative input end of the second comparator 331. The second comparison module 330 may output a second comparison signal to the logic operation module 340. For example, by configuring the values of resistors R6 - R7 and the voltage value of the second comparison voltage source, the second comparison module 330 may output a low level to the logic operation module 340 when the pre-charging current is less than the second current threshold, and may output a high level to the logic operation module 340 when the pre-charging current is higher than the second current threshold. As an example, the resistance value of the resistor R6 may be 1 kΩ, the resistance value of the resistor R7 may be 1,000 kΩ, and the voltage value of the second comparison voltage source may be 1.6V.

The logic operation module 340 may include a buffer 341, an OR logic 342, an AND logic 343, and a latch 344. The buffer 341 may enhance the signal and isolate the load, so as to avoid the mutual influence of resistance between input and output. The input end of the buffer 341 may be connected to the output end of the second comparator 331, and the output end of the buffer 341 may be connected to the first input end of the OR logic 342. The first input end of the OR logic 342 may be connected to the output end of the buffer 341, the second input end of the OR logic 342 may be connected to the latch 344, and the output end of the OR logic 342 may be connected to the first input end of the AND logic 343. The first input end of the AND logic 343 may be connected to the output end of the OR logic 342, the second input end of the AND logic 343 may be connected to the output end of the first comparator 321, and the output end of the AND logic 343 may be connected to the input end of the latch 344. In addition, the output end of the AND logic 343 as the output end of the pre-charging device may be configured to output a control signal indicating the driver device 206 in FIG. 2 to turn on or off the first switching device 102. For example, the control signal may be input to the OR logic 204 in FIG. 2.

In response to entering the pre-charging mode, when the pre-charging current is less than the first current threshold, the first comparison module 320 may output a first comparison signal as a low level, and the second comparison module 330 may output a second comparison signal as a low level. When the low level of the first comparison signal is input to the second input end of the AND logic 343, the output end of the AND logic 343 may output a low level as a control signal, thereby indicating the driver device 206 in FIG. 2 to output a drive signal to turn on the first switching device 102.

Since the first switching device 102 is turned on, the magnitude of the pre-charging current increases. When the pre-charging current increases to a value greater than the first current threshold and less than the second current threshold, the first comparison module 320 may output a first comparison signal as a high level, and the second comparison module 330 may output a second comparison signal as a low level. The latch 344 may output its latched low level output by the AND logic 343. The OR logic 342 may output a low level based on the low level input by the latch 344 and the low level output by the second comparison module 330. Based on the high level input by the first comparison module 320 and the low level output by the OR logic 342, the output end of the AND logic 343 may output a low level as a control signal, thereby indicating the driver device 206 in FIG. 2 to output a drive signal to turn on the first switching device 102.

When the pre-charging current increases to a value greater than the second current threshold, the first comparison module 320 may output a first comparison signal as a high level, and the second comparison module 330 may output a second comparison signal as a high level. The latch 344 may output its latched low level output by the AND logic 343. The OR logic 342 may output a high level based on the low level input by the latch 344 and the high level output from the second comparison module 330. Based on the high level input by the first comparison module 320 and the high level output from the OR logic 342, the output end of the AND logic 343 may output a high level as a control signal, thereby indicating the driver device 206 in FIG. 2 to output a drive signal to turn off the first switching device 102.

Since the first switching device 102 is turned off, the magnitude of the pre-charging current decreases. When the pre-charging current decreases to a value greater than the first current threshold and less than the second current threshold, the first comparison module 320 may output a first comparison signal as a high level, and the second comparison module 330 may output a second comparison signal as a low level. The latch 344 may output its latched high level output by the AND logic 343. The OR logic 342 may output a high level based on the high level input by the latch 344 and the low level output by the second comparison module 330. Based on the high level input by the first comparison module 320 and the high level output by the OR logic 342, the output end of the AND logic 343 may output a high level as a control signal, thereby indicating the driver device 206 in FIG. 2 to output a drive signal to turn off the first switching device 102.

When the pre-charging current is again less than the first current threshold, the first comparison module 320 may output a first comparison signal as a low level, and the second comparison module 330 may output a second comparison signal as a low level. When the low level as the first comparison signal is input to the second input end of the AND logic 343, the output end of the AND logic 343 may output a low level as a control signal, thereby indicating the driver device 206 in FIG. 2 to output a drive signal to turn on the first switching device 102.

During the pre-charging process, the level of the control signal output by the AND logic 343, which serves as the control signal of output end of the pre-charging device, may be repeatedly switched to indicate the first switching device 102 to be turned on or off. For example, during the pre-charging process, the level of the control signal output by the pre-charging device may be switched for the third threshold time. In this way, the pre-charging circuit may hysteresis the magnitude of the pre-charging current between the first current threshold and the second current threshold, thereby improving the pre-charging speed without affecting the life of the circuit device.

When the pre-charging process is completed, the control signal output by the pre-charging device may maintain a fixed level for at least a third threshold time. The fixed level may refer to a level at which no switching behavior occurs from a low level to a high level or from a high level to a low level. As an example, the fixed level may be a level indicating that the first switching device 102 is turned on. The third threshold time may be set depending on the specific configuration and is not limited in this disclosure.

In one embodiment, the pre-charging device may continuously output a control signal with a fixed level and the control signal no longer switches. Such a control signal may indicate that the pre-charging process is completed.

FIG. 4 is a flowchart of a method for pre-charging circuit according to an embodiment of the present disclosure.

As shown in FIG. 4, the method for pre-charging circuit may include steps S410 - S450. Steps S410 - S450 in FIG. 4 are provided as an example, but those skilled in the art will appreciate that some steps may be omitted, added, or performed in reverse order or in parallel.

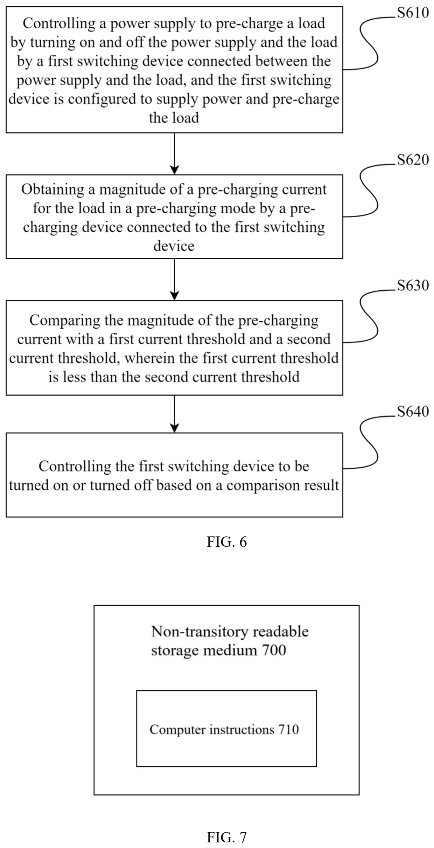

In step S410, the load may be pre-charged by the pre-charging circuit. For example, the load may be pre-charged by the pre-charging circuit in the pre-charging mode. The specific process of pre-charging the load by the pre-charging circuit may be referred to the description of FIG. 6 below.

In step S420, whether the pre-charging process is completed may be determined. In one embodiment, the control signal output by the pre-charging device of FIGs. 1-3 maintaining a fixed level for at least a third threshold time may indicate that pre-charging is completed. A level switch of the control signal output by the pre-charging device during the third threshold time may indicate that pre-charging is not completed. In an optional embodiment, the voltage difference between the power supply and the load less than the threshold voltage difference may indicate that pre-charging is completed, while the voltage difference between the power supply and the load greater than the threshold voltage difference may indicate that pre-charging is not completed. If the voltage difference between the power supply and the load is less than the threshold voltage difference, the process proceeds to step S450.

In step S450, the pre-charging mode may be exited and the first switching device may be turned on. For example, after the pre-charging is completed, the pre-charging mode may be exited and the first switching device may be turned on to supply power to the load.

In step S430, whether the pre-charging time is greater than a second threshold time may be determined. For example, if the pre-charging is not completed after the second threshold time has passed, it may indicate that a short circuit fault has occurred. If the pre-charging time is not greater than the second threshold time, the process may return to step S410.

When the pre-charging time is greater than the second threshold time, the process may proceed to step S440. In step S440, the pre-charging mode may be exited and the first switching device may be turned off. For example, in response to determining that a short circuit fault has occurred, the pre-charging mode may be exited and the first switching device may be turned off.

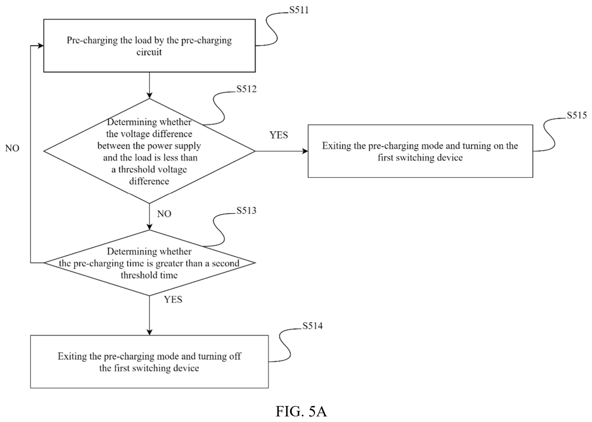

FIGs. 5A - 5C are flowcharts of another method for pre-charging circuit according to an embodiment of the present disclosure.

As shown in FIG. 5A, the method for pre-charging circuit may include steps S511 - S515. Steps S511 - S515 in FIG. 5A are provided as an example, but those skilled in the art will appreciate that some steps may be omitted, added, or performed in reverse order or in parallel.

In step S511, the load may be pre-charged by the pre-charging circuit. For example, a pre-charging mode may be entered in response to a switch-on command, and the load may be pre-charged by the pre-charging circuit in the pre-charging mode. The specific process of pre-charging the load by the pre-charging circuit may be referred to the description of FIG. 6 below.

In step S512, whether the voltage difference between the power supply and the load is less than a threshold voltage difference may be determined. For example, the voltage difference less than the threshold voltage difference may indicate that pre-charging is completed, while the voltage difference greater than the threshold voltage difference may indicate that pre-charging is not completed. If the voltage difference between the power supply and the load is less than the threshold voltage difference, the process proceeds to step S515.

In step S515, the pre-charging mode may be exited and the first switching device may be turned on. For example, after the pre-charging is completed, the pre-charging mode may be exited and the first switching device may be turned on to supply power to the load.

In step S513, whether the pre-charging time is greater than a second threshold time may be determined. For example, if the pre-charge is not completed after the second threshold time has passed, it may indicate that a short circuit fault has occurred. If the pre-charging time is not greater than the threshold time, the process may return to step S511.

When the pre-charging time is greater than the second threshold time, the process may proceed to step S514. In step S514, the pre-charging mode may be exited and the first switching device may be turned off. For example, in response to determining that a short circuit fault has occurred, the pre-charging mode may be exited and the first switching device may be turned off.

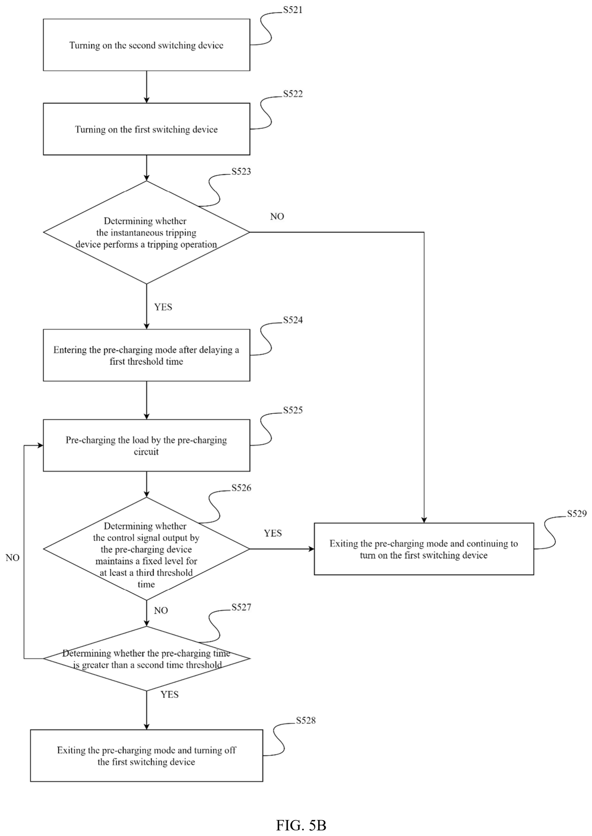

As shown in FIG. 5B, the method for pre-charging circuit may include steps S521 - S529. Steps S521 - S529 in FIG. 5B are provided as an example, but those skilled in the art will appreciate that some steps may be omitted, added, or performed in reverse order or in parallel. The scenario depicted in FIG. 5B may correspond to a normal load power-on process.

In step S521, the second switching device may be turned on. For example, the second switching device may be turned on manually on-site by a user or by remote control.

In step S522, the first switching device may be turned on. For example, the control device described above may determine that the second switching device is turned on based on the operating state of the second switching device. Therefore, the control device may control the first switching device to be turned on in response to the second switching device being turned on to supply power to the load.

In step S523, whether the instantaneous tripping device performs a tripping operation may be determined. For example, the control device described above may determine whether the instantaneous tripping device performs a tripping operation based on the operating state of the instantaneous tripping device. In one embodiment, the capacitive component in the line may be relatively low and no other tripping events such as surge current have occurred. Therefore, the current detected by the current detection module is low, and the instantaneous tripping device does not perform a tripping operation. In this case, the process may proceed to step S529. In step S529, the pre-charging mode may not be entered, and the first switching device may continue to be turned on to charge the load. In another embodiment, the capacitive component in the line may be relatively high or a tripping event such as surge current has occurred. Therefore, the current detected by the current detection module is high, and the instantaneous tripping device performs a tripping operation. In this case, the process may proceed to step S524.

In step S524, the control device may enter the pre-charging mode after delaying a first threshold time. As described above, by delaying the first threshold time, a tripping event such as a surge current may be avoided.

In step S525, the load may be pre-charged by the pre-charging circuit. For example, the control device may control the pre-charging circuit (e.g., the pre-charging device) to enter a pre-charging mode to pre-charge the load. The specific process of pre-charging the load by the pre-charging circuit may be referred to the description of FIG. 6 below.

In step S526, whether the control signal output by the pre-charging device maintains a fixed level for at least a third threshold time may be determined. As described above, during the pre-charging process, the level of the control signal output by the pre-charging device may be repeatedly switched, thereby indicating the first switching device to be turned on or off to pre-charge the load. When the pre-charging process is completed, the control signal output by the pre-charging device may maintain a fixed level for at least the third threshold time. In response to the control signal output by the pre-charging device maintaining a fixed level for at least the third threshold time, the process may proceed to step S529. In step S529, the pre-charging mode may be exited and the first switching device may continue to be turned on to supply power to the load. In response to the level of the control signal output by the pre-charging device switch for the third threshold time, the process may proceed to step S527.

In step S527, whether the pre-charging time is greater than a second threshold time may be determined. For example, a case in which pre-charging is not completed after the pre-charging time exceeds the second threshold time may indicate that a short-circuit fault has occurred. If the pre-charging time is not greater than the threshold time, the process may return to step S525.

When the pre-charging time is greater than the second threshold time, the process may proceed to step S528. In step S528, the pre-charging mode may be exited and the first switching device may be turned off. For example, in response to determining that a short circuit fault has occurred, the pre-charging mode may be exited and the first switching device may be turned off.

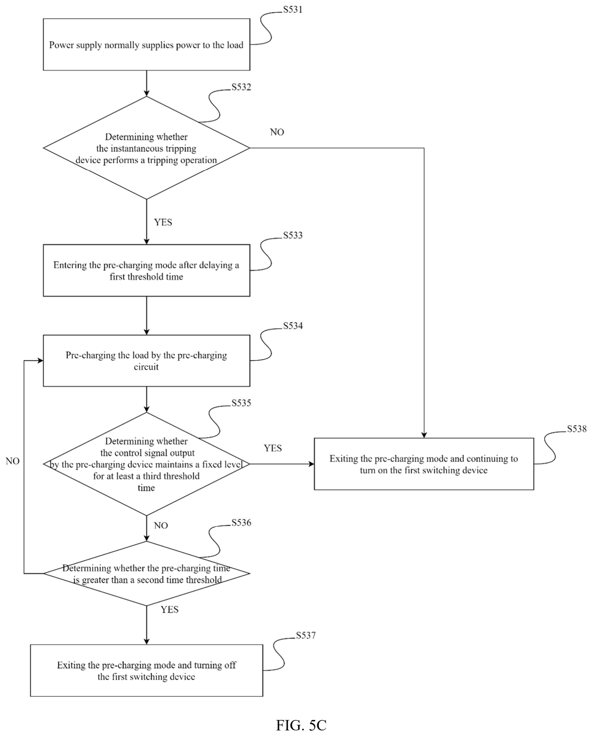

As shown in FIG. 5C, the method for pre-charging circuit may include steps S531-S538. Steps S531-S538 in FIG. 5C are provided as an example, but those skilled in the art will understand that some steps may be omitted, added, or performed in reverse order or in parallel. The scenario depicted in FIG. 5C may correspond to a process in which a tripping event occurs during normal power supply to a load.

In step S531, the power supply may supply power to the load normally. For example, after the power-on process shown in FIG. 5B, the power supply may supply power to the load normally.

In step S532, whether the instantaneous tripping device performs a tripping operation may be determined. For example, the control device described above may determine whether the instantaneous tripping device performs a tripping operation based on the operating state of the instantaneous tripping device. In one embodiment, a tripping event such as a surge current may not have occurred, so the current detected by the current detection module is low and the instantaneous tripping device does not perform tripping operation. In this case, the process may proceed to step S538. In step S538, the pre-charging mode may not be entered, and the first switching device may continue to be turned on to charge the load. In another embodiment, a tripping event such as a surge current may have occurred, so the current detected by the current detection module is high and the instantaneous tripping device performs a tripping operation. In this case, the process may proceed to step S533.

In step S533, the control device may enter the pre-charging mode after delaying a first threshold time. As described above, by delaying the first threshold time, tripping events such as surge current may be avoided. The reason for entering pre-charging mode is that during the delayed first threshold time, the energy stored in the capacitive component of the line may be consumed. Therefore, when attempting to turn on the first switching device again, a higher charging current may be generated.

In step S534, the load may be pre-charged by the pre-charging circuit. For example, the control device may control the pre-charging circuit (e.g., the pre-charging device) to enter a pre-charging mode to pre-charge the load. The specific process of pre-charging the load by the pre-charging circuit may be referred to the description of FIG. 6 below.

In step S535, whether the control signal output by the pre-charging device maintains a fixed level for at least a third threshold time may be determined. As described above, during the pre-charging process, the level of the control signal output by the pre-charging device may be repeatedly switched, thereby indicating the first switching device to be turned on or off to pre-charge the load. When the pre-charging process is completed, the control signal output by the pre-charging device may maintain a fixed level for at least the third threshold time. In response to the control signal output by the pre-charging device maintaining a fixed level for at least the third threshold time, the process may proceed to step S538. In step S538, the pre-charging mode may be exited and the first switching device may continue to be turned on to supply power to the load. In response to the level of the control signal output by the pre-charging device switching for the third threshold time, the process may proceed to step S536.

In step S536, whether the pre-charging time is greater than a second threshold time may be determined. For example, a case in which pre-charging is not completed after the pre-charging time exceeds the second threshold time may indicate that a short-circuit fault has occurred. If the pre-charging time is not greater than the threshold time, the process returns to step S534.

When the pre-charging time is greater than the second threshold time, the process may proceed to step S537. In step S537, the pre-charging mode may be exited and the first switching device may be turned off. For example, in response to determining that a short circuit fault has occurred, the pre-charging mode may be exited and the first switching device may be turned off.

As shown in FIG. 6, the method for pre-charging circuit may include steps S610 - S640. Steps S610-S640 may correspond to step S410 in FIG. 4, step S511 in FIG. 5A, step S525 in FIG. 5B, and step S534 in FIG. 5C.

In step S610, the power supply and the load may be turned on and off by a first switching device connected between the power supply and the load to control the power supply to pre-charge the load, and the first switching device is configured to supply power and pre-charge the load.

In step S620, the magnitude of the pre-charging current for the load may be obtained in the pre-charging mode by the pre-charging device connected to the first switching device.

In step S630, the magnitude of the pre-charging current may be compared with a first current threshold and a second current threshold, wherein the first current threshold is less than the second current threshold.

In step S640, the first switching device may be controlled to be turned on or off based on a comparison result.

FIG. 7 is a non-transitory computer-readable storage medium according to at least one embodiment of the present disclosure.

As shown in FIG. 7, a non-transitory readable storage medium 700 stores computer instructions 710, which, when executed by a processor, perform one or more steps of the various methods and additional aspects thereof as described above.

Exemplarily, the non-transitory readable storage medium 700 may be any combination of one or more computer-readable storage media. For example, a computer-readable storage medium may contain program codes for executing the various methods described above.

Exemplarily, when the program code is read by a computer, the computer may execute the program code stored in the computer storage medium to implement, for example, one or more steps of the various methods and additional aspects thereof according to at least one embodiment of the present disclosure.

Exemplarily, the non-transitory readable storage medium may include a memory card of a smartphone, a storage part of a tablet computer, a hard disk of a personal computer, a random-access memory (RAM), a read-only memory (ROM), an erasable programmable read-only memory (EPROM), a portable compact disk read-only memory (CD-ROM), a flash memory, and other non-transitory readable storage media or any combination thereof.

The pre-charging circuit described above with reference to FIGS. 1-6 may be installed in a solid-state circuit breaker. According to at least one embodiment of the present disclosure, a solid-state circuit breaker including the pre-charging circuit is provided.

The pre-charging circuit according to the present disclosure can accurately control the magnitude of the pre-charging current during the process of pre-charging the load. Furthermore, the pre-charging circuit has the advantages of less required devices, low cost, small occupied space and fast pre-charging speed. Furthermore, in the pre-charging circuit according to the present disclosure, the MCU may determine whether to enter pre-charging mode, that is, whether to activate the pre-charging device. However, in pre-charging mode, controlling the switching device to be turned off based on the comparison result of the magnitude of the pre-charging current with the first current threshold and the second current threshold is performed by the pre-charging device composed of hardware. In this way, the occupation of the computing resources of the MCU can be reduced. However, the present disclosure is not limited to this, and the above comparison operation may be performed by outputting a comparison voltage (for example, voltages corresponding to the first comparison voltage source and the second comparison voltage source in FIG. 3) as a voltage corresponding to the pre-charging current via a digital-to-analog converter included in the MCU. Furthermore, the frequency of controlling the switching device to be turned off based on the comparison result of the pre-charging current with the first current threshold and second current threshold in pre-charging mode may be very high, and most MCUs are unable to perform such a high-frequency comparison and control.

Although the disclosure has been described with exemplary embodiments, various changes and modifications can be suggested to those skilled in the art. The disclosure intends to cover such changes and modifications that fall within the scope of the appended claims.

Any description in this disclosure should not be understood as implying that any specific element, step or function is an essential element that must be included in the scope of the claims. The scope of the patent subject matter is limited only by the claims.

## Claims

1. A pre-charging circuit comprising:
a first switching device connected between a power supply and a load, configured to turn on and off the power supply and the load to control power supplying and pre-charging of the load by the power supply; and
a pre-charging device connected to the first switching device, configured to, in a pre-charging mode:
obtain a magnitude of a pre-charging current for the load,
compare the magnitude of the pre-charging current with a first current threshold and a second current threshold, wherein the first current threshold is less than the second current threshold, and
control the first switching device to be turned on or turned off based on a comparison result.

2. The pre-charging circuit of claim 1, further comprising a voltage clamping device connected in parallel with switching device, wherein,
the voltage clamping device conducts a pre-charging current flowing through the load in the pre-charging mode, in response to the first switching device being turned off.

3. The pre-charging circuit of claim 1, further comprising a control device configured to control the pre-charging device to enter or exit the pre-charging mode.

4. The pre-charging circuit of claim 3, further comprising a voltage measurement device, the control device is configured to:
measure a power supply voltage and a load voltage by the voltage measurement device,
enter the pre-charging mode, based on a voltage difference between the power supply voltage and the load voltage being greater than a voltage difference threshold.

5. The pre-charging circuit of claim 3, wherein the control device is further configured to:
detect whether a second switching device changes from an off state to an on state, wherein the second switching device is connected in series with the first switching device and comprises a mechanical switch,
control the pre-charging device to enter the pre-charging mode, in response to detecting that the second switching device changes from the off state to the on state.

6. The pre-charging circuit of claim 5, wherein the control device is further configured to:
control the first switching device to be turned on, in response to detecting that the second switching device changes from the off state to the on state,
determine whether an instantaneous tripping device turns off the first switching device,
control the pre-charging device to enter the pre-charging mode after a first threshold time, in response to determining that the instantaneous tripping device turns off the first switching device.

7. The pre-charging circuit of claim 3, wherein the control device is further configured to:
determine whether the instantaneous tripping device turns off the first switching device in the case that the power supply supplies power to the load through the first switching device being turned on and the second switching device being turned on, wherein the second switching device is connected in series with the first switching device and comprises a mechanical switch,
control the pre-charging device to enter the pre-charging mode after a first threshold time, in response to determining that the instantaneous tripping device turns off the first switching device.

8. The pre-charging circuit of claim 3, wherein the control device is configured to control the pre-charging device to exit the pre-charging mode based on at least one of the following:
the pre-charging device completes the pre-charging of the load;
the pre-charging of the load is not completed, in the case that a pre-charging time is greater than a second threshold time.

9. The pre-charging circuit of claim 3, wherein the control device is configured to:
in response to the pre-charging device completing the pre-charging of the load, control the pre-charging device to exit the pre-charging mode and continue to turn on the first switching device.

10. The pre-charging circuit of claim 8, further comprising a voltage measurement device, the control device is configured to:
measure a power supply voltage and a load voltage by the voltage measurement device,
determine that the pre-charging device completes the pre-charging of the load, based on a voltage difference between the power supply voltage and the load voltage being smaller than a voltage difference threshold.

11. The pre-charging circuit of claim 8,
wherein the pre-charging device is configured to output a control signal having a first level to indicate the first switching device to be turned on, and output a control signal having a second level to indicate the first switching device to be turned off,
wherein the control device is further configured to:
in response to the control signal output by the pre-charging device maintaining the first level for at least a third threshold time, determine that the pre-charging device completes the pre-charging of the load.

12. The pre-charging circuit of claim 8, wherein the control device is further configured to:
in response to the pre-charging of the load not being completed in the case that the pre-charging time is greater than the second threshold time, exit the pre-charging mode and turn off the first switching device.

13. The pre-charging circuit of claim 8,
wherein the pre-charging device is configured to output a control signal with a first level to indicate the first switching device to be turned on, and output a control signal with a second level to indicate the first switching device to be turned off,
wherein the control device is further configured to: in response to the control signal output by the pre-charging device switching between the first level and the second level for a third threshold time, determine that the pre-charging device does not complete the pre-charging of the load.

14. The pre-charging circuit of claim 8, further comprising a voltage measurement device, the control device is configured to:
measure a power supply voltage and a load voltage by the voltage measurement device,
determine that the pre-charging device does not complete the pre-charging of the load, based on a voltage difference between the power supply voltage and the load voltage being greater than a voltage difference threshold.

15. The pre-charging circuit of claim 3, further comprising a driver device configured to drive the first switching device to be turned on or turned off based on a control signal.
